# EUROPÄISCHE PATENTSCHRIFT

(11) **EP 1 247 112 B1**
(45) Veröffentlichungstag und Bekanntmachung des Hinweises auf die Patenterteilung: **04.08.2004**
(21) Anmeldenummer: 01907421.0
(22) Anmeldetag: 09.01.2001
(51) Int. Cl.: G01R 31/28

(54) **SCHALTUNGSANORDNUNG ZUR SIMULATION DER EINGANGS- ODER AUSGANGSLAST EINER ANALOGSCHALTUNG**
CIRCUIT ARRANGEMENT FOR SIMULATION OF THE INPUT OR OUTPUT LOAD OF AN ANALOGUE CIRCUIT
ENSEMBLE CIRCUIT POUR SIMULER LA CHARGE D'ENTREE OU DE SORTIE D'UN CIRCUIT ANALOGIQUE

(30) Priorität: 13.01.2000 DE 10001154
(43) Veröffentlichungstag der Anmeldung: 09.10.2002
(73) Patentinhaber: Infineon Technologies AG, 81669 München (DE)
(72) Erfinder: SCHERR, Wolfgang, A-9556 Liebenfels (AT)
(74) Vertreter: Bickel, Michael
(86) Internationale Anmeldenummer: PCT/EP2001/000169
(87) Internationale Veröffentlichungsnummer: WO 2001/051938

(56) Entgegenhaltungen:
- US-A- 5 945 822
- TAYLOR S S: "A HIGH-PERFORMANCE GAAS PIN ELECTRONICS CIRCUIT FOR AUTOMATIC TEST EQUIPMENT" IEEE JOURNAL OF SOLID-STATE CIRCUITS,US,IEEE INC. NEW YORK, Bd. 28, Nr. 10, 1. Oktober 1993 (1993-10-01), Seiten 1023-1029, XP000400097 ISSN: 0018-9200
- JUNG-CHIEN LI ET AL: "A study on an AC active load simulator" PROCEEDINGS OF THE IEEE INTERNATIONAL SYMPOSIUM ON INDUSTRIAL ELECTRONICS (CAT. NO.92TH0371-5), XIAN, CHINA, 25-29 MAY 1992, Seiten 69-73 vol.1, XP002168966 1992, New York, NY, USA, IEEE, USA ISBN: 0-7803-0042-4

## Beschreibung

Die Erfindung betrifft eine Schaltungsanordnung zur Simulation der Eingangs- oder Ausgangslast einer Analogschaltung.

Es ist bekannt, zur Simulation der Eingangs- oder Ausgangslast einer Analogschaltung steuerbare Strom- oder Spannungsquellen vorzusehen, die von einem Digitalsimulator gesteuert werden. Die Ausgangsströme oder Ausgangsspannungen der gesteuerten Strom- oder Spannungsquellen werden über RC-Glieder in die Analogschaltung eingekoppelt.

Weil derartige Schaltungsanordnungen jedoch die Eingangs- oder Ausgangslast Analogschaltungen mit kritischen Eingangssignalen nicht genügend realitätsnah simulieren können, ist eine zusätzliche analoge Simulation erforderlich.

Die US 5,945,822 beschreibt eine programmierbare Lastschaltung mit zwei Stromquellen, die als Last für eine zu testende Schaltungsanordnung dienen. Die Lastschaltung umfasst weiterhin eine zwischen die Stromquellen schaltbare Diodenbrücke und an die Diodenbrücke anschließbare parasitäre Kapazitäten.

Taylor S. S.: "A HIGH-PERFORMANCE GAAS PIN ELECTRONICS CIRCUIT FOR AUTOMATIC TEST EQUIPMENT' IEEE JOURNAL OF SOLID-STATE CICUITS"; US; IEEE INC. NEW YORK, Bd. 28, Nr. 10, 1. Oktober 1993, Seiten 1023-1029, beschreibt ein unter Verwendung von GaAs-MESFET realisiertes Testsystem.

Jung-Chien Li et al.: " A study on an AC active load simulator" PROCEEDINGS OF THE IEEE INTERNATIONAL SYMPOSIUM ON INDUSTRIAL ELECTRONICS (CAT. NO. 92TH0371-%); XIAN, CHINA, 25-29 MAY 1992, Seiten 69-73, beschreibt einen aktiven Lastsimulator zur Simulation induktiver und kapazitiver Lasten.

Es ist Aufgabe der Erfindung, eine Schaltungsanordnung zur Simulation der Eingangs- oder Ausgangslast einer Analogschaltung so zu gestalten, dass die Simulation auch bei kritischen Eingangssignalen realitätsnah erfolgt.

Eine erste im Anspruch 1 beschriebene Lösung dieser Aufgabe sieht vor, dass der Ausgang der Analogschaltung mit dem Eingang einer Treiberstufe verbunden ist, dass zur Erfassung der Ausgangsspannung der Analogschaltung ein Messelement zwischen dem Eingang der Treiberstufe und Bezugspotential liegt und dass zwischen dem Ausgang der Treiberstufe und Bezugspotential ein steuerbarer Kopplungswiderstand liegt, dessen Steuereingang mit dem Steuerausgang eines Digitalsimulators verbunden ist.

Eine zweite im Anspruch 2 beschriebene Lösung dieser Aufgabe sieht vor, dass der Ausgang einer Treiberstufe mit dem Eingang der Analogschaltung verbunden ist, dass am Eingang der Treiberstufe eine Parallelschaltung aus einer ersten steuerbaren Strom- oder Spannungsquelle, aus einem ersten Widerstand und aus einer ersten Kapazität liegt und dass der Steuereingang der ersten steuerbaren Strom- oder Spannungsquelle mit dem ersten Steuerausgang eines Digitalsimulators verbunden ist.

Durch den erfindungsgemäßen Einsatz einer Treiberstufe gestaltet sich die Simulation wesentlich realitätsnäher, ohne dass hierzu ein großer technischer Aufwand erforderlich ist.

Die Erfindung wird anhand der in den Figuren gezeigten Ausfuhrungsbeispiele näher beschrieben und erläutert. In der Zeichnung zeigen:
- Fig. 1: ein Ausführungsbeispiel der Erfindung zur Simulation der Ausgangslast einer Analogschaltung,
- Fig. 2: ein Ausführungsbeispiel der Erfindung zur Simulation der Eingangslast einer Analogschaltung,
- Fig. 3: ein Ausfuhrungsbeispiel der Erfindung zur Simulation der Eingangs- oder Ausgangslast einer Analogschaltung und
- Fig. 4: ein weiteres Ausführungsbeispiel der Erfindung zur Simulation der Eingangs- oder Ausgangslast einer Analogschaltung.

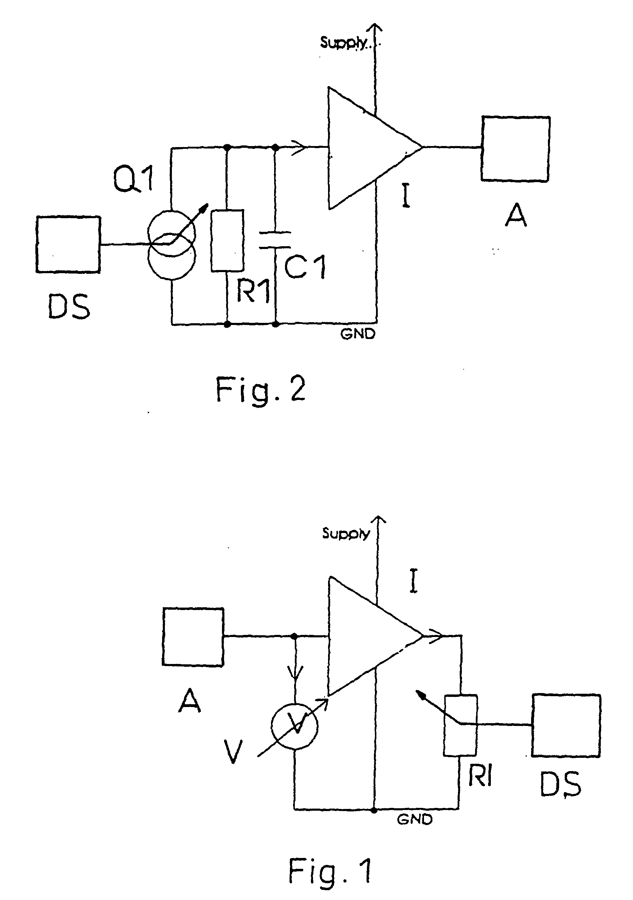

Bei der in Fig. 1 abgebildeten Schaltungsanordnung zur Simulation der Ausgangslast einer Analogschaltung A ist deren Ausgang mit dem Eingang einer Treiberstufe I verbunden. Der Ausgang der Treiberstufe I liegt über einem steuerbaren Kopplungswiderstand RI auf Bezugspotential, dessen Steuereingang mit dem Steuerausgang eines Digitalsimulators DS verbunden ist. Zwischen dem Eingang der Treiberstufe I und Bezugspotential liegt ein Messelement V zur Erfassung der Ausgangsspannung der Analogschaltung A.

Der Digitalsimulator DS simuliert durch Verändern des Kopplungswiderstandes RI unterschiedliche Ausgangslasten für die Analogschaltung A.

In der Fig. 2 ist eine erfindungsgemäße Schaltungsanordnung zur Simulation der Eingangslast einer Analogschaltung gezeigt.

An den Eingang einer Treiberstufe I ist eine Parallelschaltung aus einer steuerbaren Stromquelle Q1, einem Widerstand R1 und einer Kapazität C1 angeschlossen. Der Steuerausgang eines Digitalsimulators DS ist an den Steuereingang der steuerbaren Stromquelle Q1 angschlossen. Der Ausgang der Treiberstufe I ist mit dem Eingang der Analogschaltung A verbunden.

Um für die Analogschaltung A unterschiedliche Eingangslasten realitätsnah zu simulieren, steuert der Digitalsimulator DS die steuerbare Stromquelle Q1.

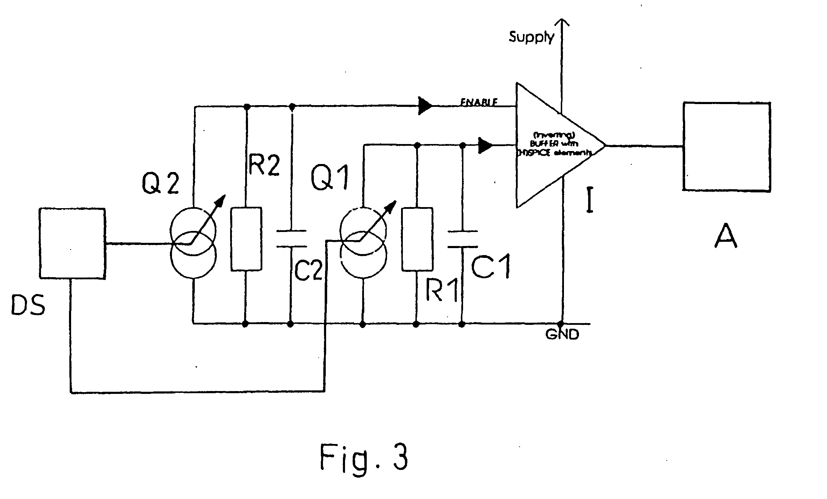

In der Fig. 3 ist ein erfindungsgemäßes Ausführungsbeispiel zur Simulation der Eingangs- oder Ausgangslast einer Analogschaltung dargestellt.

Das in der Fig. 3 abgebildete erfindungsgemäße Ausführungsbeispiel hat denselben Aufbau wie das in Fig. 2 gezeigte Ausführungsbeispiel, ist jedoch durch eine Parallelschaltung aus einer zweiten steuerbaren Stromquelle Q2 einem zweiten Widerstand R2 und einer zweiten Kapazität C2 ergänzt, die an den ENABLE-Eingang der Treiberstufe I angeschlossen ist. Der Steuereingang der Stromquelle Q2 ist mit einem zweiten Steuerausgang des Digitalsimulators DS verbunden.

Wenn an dem Ausgang der Treiberstufe I der Eingang einer Analogschaltung A angeschlossen ist, simuliert der Digitalsimulator DS durch Einschalten der Stromquelle Q2 und Steuern der Stromquelle Q1 unterschiedliche Eingangslasten für die Analogschaltung A. Ist dagegen der Ausgang der Analogschaltung A an den Ausgang der Treiberstufe I angeschlossen, wird die Treiberstufe I vom Digitalsimulator DS ausgeschaltet.

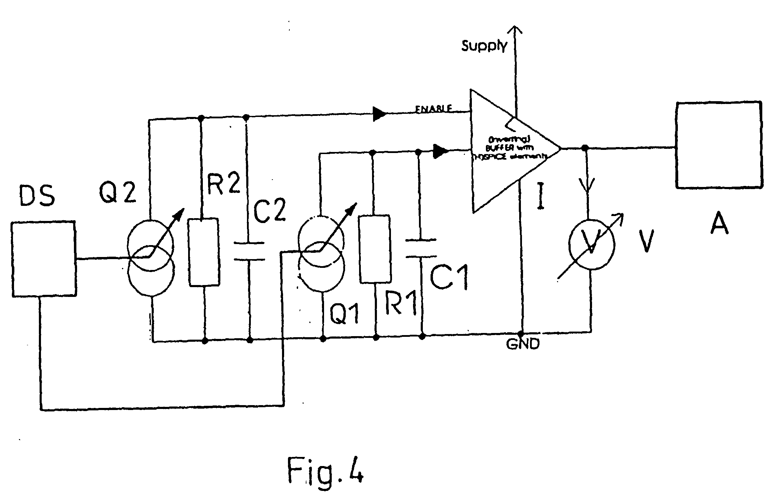

In der Fig. 4 ist ein weiteres erfindungsgemäßes Ausführungsbeispiel zur Simulation der Eingangs- oder Ausgangslast einer Analogschaltung gezeigt.

Das in der Fig. 4 abgebildete Ausführungsbeispiel der Erfindung hat denselben Aufbau wie das Ausführungsbeispiel aus Fig. 3. Zur Erfassung der Ausgangsspannung der Analogschaltung A liegt zwischen dem Ausgang der Treiberstufe I und Bezugspotential ein Messelement V.

Besonders vorteilhaft ist es, für die Treiberstufe I eine CMOS-Inverterstufe oder einen sogenannten Default-Treiber vorzusehen. Die Kopplung zur Analogschaltung erfolgt vorzugsweise über ein RC-Glied.

Die Erfindung zeichnet sich durch den Vorteil aus, dass sie auch die Simulation der Eingangs- oder Ausgangslast einer Analogschaltung mit kritischen Eingangssignalen genügend realitätsnah durchführt, so dass zusätzliche Simulationen nicht mehr erforderlich sind.

## Patentansprüche

1. Schaltungsanordnung zur Simulation der Ausgangslast einer Analogschaltung (A),
**dadurch gekennzeichnet, dass** der Ausgang der Analogschaltung (A) mit dem Eingang einer Treiberstufe (I) verbunden ist, dass zur Erfassung der Ausgangsspannung der Analogschaltung (A) ein Messelement (V) zwischen dem Eingang der Treiberstufe (I) und Bezugspotential liegt und dass zwischen dem Ausgang der Treiberstufe (I) und Bezugspotential ein steuerbarer Kopplungswiderstand (RI) liegt, dessen Steuereingang mit dem Steuerausgang eines Digitalsimulators (DS) verbunden ist.

2. Schaltungsanordnung zur Simulation der Eingangs last einer Analogschaltung (A),
**dadurch gekennzeichnet, dass** der Ausgang einer Treiberstufe (I) mit dem Eingang der Analogschaltung (A) verbunden ist, dass am Eingang der Treiberstufe (I) eine Parallelschaltung aus einer ersten steuerbaren Strom- oder Spannungsquelle (Q1), aus einem ersten Widerstand (R1) und aus einer ersten Kapazität (C1) liegt und dass der Steuereingang der ersten steuerbaren Strom- oder Spannungsquelle (Q1) mit dem ersten Steuerausgang eines Digitalsimulators (DS) verbunden ist.

3. Schaltungsanordnung nach Anspruch 2,
**dadurch gekennzeichnet, dass** an den ENABLE-Eingang der Treiberstufe (I) eine Parallelschaltung aus einer zweiten steuerbaren Strom- oder Spannungsquelle (Q2), aus einem zweiten Widerstand (R2) und aus einer zweiten Kapazität (C2) angeschlossen ist und dass der Steuereingang der zweiten Strom- oder Spannungsquelle (Q2) mit dem zweiten Steuerausgang des Digitalsimulators (DS) verbunden ist.

4. Schaltungsanordnung nach Anspruch 3,
**dadurch gekennzeichnet, dass** zwischen dem Ausgang der Treiberstufe (I) und Bezugspotential ein Messelement (V) liegt.

5. Schaltungsanordnung nach Anspruch 1, 2, 3 oder 4,
**dadurch gekennzeichnet, dass** die Treiberstufe (I) als Inverterstufe aufgebaut ist.

6. Schaltungsanordnung nach Anspruch 5,
**dadurch gekennzeichnet, dass** die Treiberstufe (I) in CMOS-Technik ausgeführt ist.

7. Schaltungsanordnung nach Anspruch 5 oder 6,
**dadurch gekennzeichnet, dass** für die Treiberstufe (I) ein Default-Treiber vorgesehen ist.

8. Schaltungsanordnung nach einem der vorangehenden Ansprüche 2 bis 7,
**dadurch gekennzeichnet, dass** zur Auskopplung in die Analogschaltung (A) RC-Glieder vorgesehen sind.

## Claims

1. Circuit arrangement for simulating the output load of an analog circuit (A), **characterized in that** the output of the analog circuit (A) is connected to the input of a driver stage (I), **in that** a measuring element (V) is situated between the input of the driver stage (I) and earth in order to detect the output voltage of the analog circuit (A), and **in that** situated between the output of the driver stage (I) and earth is a controllable coupling resistor (RI) whose control input is connected to the control output of a digital simulator (DS).

2. Circuit arrangement for simulating the input load of an analog circuit (A), **characterized in that** the output of a driver stage (I) is connected to the input of the analog circuit (A), **in that** a parallel circuit composed of a first controllable current or voltage source (Q1), of a first resistor (RI) and of a first capacitor (C1) is situated at the input of the driver stage (I), and **in that** the control input of the first controllable current or voltage source (Q1) is connected to the first control output of a digital simulator (DS).

3. Circuit arrangement according to Claim 2, **characterized in that** a parallel circuit composed of a second controllable current or voltage source (Q2), of a second resistor (R2) and of a second capacitor (C2) is connected to the ENABLE input of the driver stage (I), and **in that** the control input of the second current or voltage source (Q2) is connected to the second control output of the digital simulator (DS).

4. Circuit arrangement according to Claim 3, **characterized in that** a measuring element (V) is situated between the output of the driver stage (I) and earth.

5. Circuit arrangement according to Claim 1, 2, 3 or 4, **characterized in that** the driver stage (I) is constructed as an inverter stage.

6. Circuit arrangement according to Claim 5, **characterized in that** the driver stage (I) is designed using CMOS technology.

7. Circuit arrangement according to Claim 5 or 6, **characterized in that** a default driver is provided for the driver stage (I).

8. Circuit arrangement according to one of the preceding Claims 2 to 7, **characterized in that** RC elements are provided for decoupling into the analog circuit (A).

## Revendications

1. Ensemble circuit pour simuler la charge de sortie d'un circuit analogique (A),
**caractérisé en ce que**
la sortie du circuit analogique (A) est reliée à l'entrée d'un étage de puissance (I), un élément (V) de mesure se trouve entre l'entrée de l'étage de puissance (I) et le potentiel de référence pour l'acquisition de la tension de sortie du circuit analogique (A), et entre la sortie de l'étage de puissance (I) et le potentiel de référence se trouve une résistance de couplage pilotable (RI) dont l'entrée de commande est reliée avec la sortie de commande d'un simulateur numérique (DS).

2. Ensemble circuit pour simuler la charge d'entrée d'un circuit analogique (A),
**caractérisé en ce que**
la sortie d'un étage de puissance (I) est reliée à l'entrée du circuit analogique (A), à l'entrée de l'étage de puissance (I) on a un circuit parallèle composé d'une première source pilotable de courant ou de tension (Q1), d'une première résistance (R1) et d'une première capacité (C1), et l'entrée de commande de la première source pilotable de courant ou de tension (Q1) est reliée avec la première sortie de commande d'un simulateur numérique (DS).

3. Ensemble circuit selon la revendication 2,
**caractérisé en ce qu'**
à l'entrée ENABLE de l'étage de puissance (I) est relié un circuit parallèle composé d'une deuxième source pilotable de courant ou de tension (Q2), d'une deuxième résistance (R2) et d'une deuxième capacité (C2), et l'entrée de commande de la deuxième source pilotable de courant ou de tension (Q2) est reliée avec la deuxième sortie de commande d'un simulateur numérique (DS).

4. Ensemble circuit selon la revendication 3,
**caractérisé en ce qu'**
un élément de mesure (V) se trouve entre la sortie de l'étage de puissance (I) et le potentiel de référence.

5. Ensemble circuit selon la revendication 1, 2, 3, ou 4,
**caractérisé en ce que**
l'étage de puissance (I) est constitué en tant qu'étage inverseur.

6. Ensemble circuit selon la revendication 5,
**caractérisé en ce que**
l'étage de puissance (I) est réalisé en technique CMOS.

7. Ensemble circuit selon la revendication 5 ou 6,
**caractérisé en ce qu'**
un « default driver », étage de puissance par défaut, est prévu pour l'étage de puissance (I).

8. Ensemble circuit selon l'une quelconque des revendications précédentes 2 à 7,
**caractérisé en ce que**
des cellules RC sont prévues dans le circuit analogique (A) pour le découplage.
